Europäisches Patentamt

**European Patent Office**

**Office européen des brevets**

(19)

(11) Publication number: **0 092 746**
**A1**

(12) # EUROPEAN PATENT APPLICATION

(21) Application number: **83103668.6**

(22) Date of filing: **15.04.83**

(51) Int. Cl.³: **G 01 R 15/08**

(30) Priority: **22.04.82 IT 2088882**

(43) Date of publication of application:
**02.11.83 Bulletin 83/44**

(84) Designated Contracting States:
**AT BE CH DE FR GB LI NL SE**

(71) Applicant: **CARLO ERBA STRUMENTAZIONE S.p.A.**

**I-20090 Rodano Milano(IT)**

(72) Inventor: **Azelio, Vavassori**
**Via Brema, 37**
**I-25019 Sirmione (Brescia)(IT)**

(74) Representative: **Marietti, Giuseppe**
**CENTRO DI CONSULENZA IN PROPRIETA'**
**INDUSTRIALE viale Caldara, 43**
**I-20122 Milano(IT)**

(54) **Electronic measuring device.**

(57) The invention concerns an electronic device for measuring direct or variable currents, comprising one or more meters. In order to obtain a high number of simultaneous outputs to cover a wide range of capacities, the outlet of at least one of the meters is subdivided into several lines in parallel, at least some of which are provided with amplifiers or attenuators of the signal with differentiated gains or ratios of attenuation.

*Fig. 1*

EP 0 092 746 A1

The present invention concerns an electronic device for measuring direct or variable currents, of the type comprising one or more meters with differentiated outputs, capable of measuring a direct or variable current, representing on its turn another physical quantity measured upstreams, in particular, even if not exclusively, in scientifical instruments used in the fields of chromatography, gas chromatography, photometry, mass spectrometry, pH measure or the like.

For the technological applications of the above mentioned type or similar applications, it is necessary to measure currents with wide dynamic range, which can reach values of about $10^{10}$ (for instance from $10^{-15}$ A to $10^{-5}$ A). To obtain reliable outputs on the whole considered range, meters of different types have been proposed and it has also been considered to place several meters, in series and differently calibrated, which provide as many as simultaneous outputs (Italian Patent Aplication N. 47925-A/82 of same Applicant). However, these solutions not always have proved to be useful and economical, above all when one wants to obtain a very high subdivision of the range, namely a relatively high number of outputs with increasing capacities according to subsequent ration of relatively reduced value. In this case, according to the known technique, it should be necessary to have a meter for each output, which would make the device unduly complicated.

To overcome said inconvenience, the invention proposes a measuring device of the type above defined, wherein the output of at least one of the meters is subdivided into two or more lines in parallel, at least some of which are provided with amplifiers or attenuators of the signal to provide a series of simultaneous outputs having different capacities.

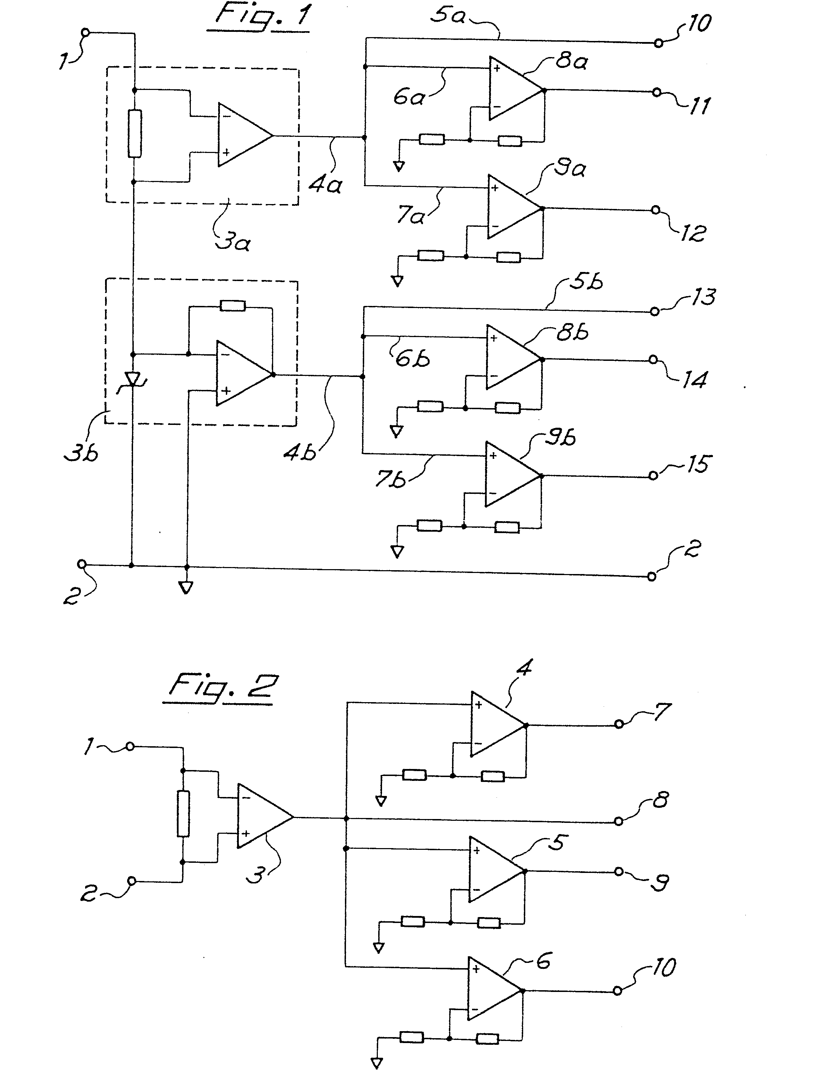

The invention will be now described more in detail with reference to examples of configuration of same, illustrated in the schemes of the attached figures 1 and 2. Referring to figure 1, a direct or variable current to be measured is applied to the terminal 1 of the device, the terminal 2 of which is placed at the common pole.

In the case illustrated, in series between the terminals 1 and 2 two meters 3a and 3b are foreseen and they can be of any known type, for instance, but not necessarily, as illustrated in the above mentioned patent application. The outlets 4a and 4b of the two meters 3a and 3b can have a ratio for example of $10^3$, which means that the sensitivity of the meter 3b is $10^3$ times higher and its capacity $10^3$ times lower than that of the meter 3a.

In case one wants to have several outputs, having increasing capacities with lower ratios, for example according to powers of 10, each of the outlets 4a and 4b of the meters 3a and 3b is subdivided into more lines, for example three lines 5a, 6a, 7a and 5b, 6b, 7b rispectively, at least some of which are provided with amplifiers or attenuators of the signal. In the shown case, the output lines 5a and 5b have no amplifier or attenuator of the signal, lines 6a and 6b are provided, for example, with an amplifier 8a and 8b having a gain of 10 each and the lines 7a and 7b are provided with an amplifier 9a and 9b having a gain of $10^2$ each. In this way, six outputs are obtained, from 11 to 15, the sensitivities of which are increasing in succession according to powers of 10, while, obviously, the capacities are decreasing accordingly. The presence of these six simultaneous lines of measure at low impedance, progressively saturating with the increase of input current, allows both the commutation of an output meter without causing transient states, and the application of the six lines themselves at the input of a data processor or of an electronic computer, which will automatically identify the most suitable line for the reading or the storage of the signal.

Figure 2 illustrates another possible configuration of the concerned device.

The reference 3 indicates a current measuring device of the "floating" type, the terminals 1 and 2 of which are isolated from the common pole. The output line 7 is preceded by an attenuator 4, having a gain of 0.1; the line 8 is a direct outlet from meter 3; the line 9 is preceded by an amplifier 5, having a gain of 10; finally, the line 10 is preceded by an amplifier 6, having a gain of 100. So it is possible to obtain a series of four lines with progressively increasing gains, in particular of 0.1, 1, 10, 100.

What hereinabove described clearly shows that the illustrated configuration can undergo different changes and variations, concerning the number and type of used meters, the number of output lines in parallel, the type of signal amplifiers or attenuators, and finally the gains or the ratios of attenuation established.

All these changes and variations must be considered as falling within the scope of the present invention.

C L A I M S

1.- An electronic device for measuring direct or variable currents, comprising one or more meters with differentiated outputs, wherein the output of at least one of the meters is subdivided into two or more lines in parallel, at least some of which are provided with amplifiers or attenuators of the signal, to supply a series of simultaneous outputs having differentiated capacities.

2.- An electronic device according to claim 1, wherein the output of each meter is subdivided into more lines in paral lel, one of which without signal amplifiers or attenuators and the others provided with signal ampllifiers or attenuators having different gains or ratios of attenuation, respectively.

3.- An electronic device according to claims 1 and 2, wherein the current meter is of a differential, symmetrical type, with an outlet at the common pole.

_Fig. 1_

1/1

0092746

_Fig. 2_

0092746

European Patent
Office

**EUROPEAN SEARCH REPORT**

Application number

EP 83 10 3668

## DOCUMENTS CONSIDERED TO BE RELEVANT

| Category | Citation of document with indication, where appropriate, of relevant passages | Relevant to claim |
|---|---|---|
| X | FR-A-2 392 541 (LEYBOLD-HERAEUS) * Figure 1; page 3, lines 35-38 * | 1 |
| A | US-A-3 807 816 (J.A. HAMBURG) * Figure 2; abstract * | 1 |
| A | FR-A-2 033 566 (COMMISSARIAT A L'ENERGIE ATOMIQUE) * Figure; claim 1 * | 1 |
| A | DE-A-1 944 982 (I.B.M.) * Figure 1; page 9, paragraph 3 * | 1 |
| A | DE-A-3 003 362 (P. GEISEL) * Claim 1 * | 1 |

CLASSIFICATION OF THE APPLICATION (Int. Cl. 3)

G 01 R 15/08

TECHNICAL FIELDS SEARCHED (Int. Cl. 3)

G 01 R

The present search report has been drawn up for all claims

| Place of search | Date of completion of the search | Examiner |
|---|---|---|
| THE HAGUE | 21-07-1983 | MIELKE W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82